Europäisches Patentamt

European Patent Office

Office européen des brevets

(19)

(11) **EP 0 409 074 B1**

(12) **EUROPÄISCHE PATENTSCHRIFT**

(45) Veröffentlichungstag und Bekanntmachung des Hinweises auf die Patenterteilung:
**02.09.1998 Patentblatt 1998/36**

(51) Int Cl.⁶: **G02F 1/01**, G02B 6/42,
H01L 27/144

(21) Anmeldenummer: **90113309.0**

(22) Anmeldetag: **12.07.1990**

(54) **Optoelektronische Anordnung**

Optical-electronic device

Dispositif optoélectronique

(84) Benannte Vertragsstaaten:
**CH DE FR GB IT LI NL SE**

(30) Priorität: **18.07.1989 DE 3923709**

(43) Veröffentlichungstag der Anmeldung:
**23.01.1991 Patentblatt 1991/04**

(73) Patentinhaber: **ALCATEL ALSTHOM COMPAGNIE GENERALE D'ELECTRICITE**
**75008 Paris (FR)**

(72) Erfinder: **Mozer, Albrecht, Dr.**
**D-7120 Bietigheim (DE)**

(74) Vertreter: **Schätzle, Albin, Dipl.-Phys.**
**Alcatel Alsthom**
**Intellectual Property Department,**
**Postfach 30 09 29**
**70449 Stuttgart (DE)**

(56) Entgegenhaltungen:
**EP-A- 0 308 948** **WO-A-85/04985**
**GB-A- 2 000 877**

- **APPLIED PHYSICS B. PHOTOPHYSICS AND CHEMISTRY. Bd. B48, Nr. 3, März 1989, HEIDELBERG DE Seiten 219 - 224; REUTER ET AL.: 'AN INTEGRATED ORGANIC PHOTOCONDUCTIVE DETECTOR FOR OPTOELECTRONICS'**
- **JOURNAL OF MOLECULAR ELECTRONICS. Bd. 4, Nr. 1, Januar 1988, CHICHESTER GB Seiten 5 - 15; POTEMBER ET AL.: 'MOLECULAR OPTICAL DEVICES'**
- **APPLIED PHYSICS LETTERS. Bd. 54, Nr. 2, 9. Januar 1989, NEW YORK US LIOU ET AL.: 'MONOLITHIC INTEGRATED InGaAsP/InP DISTRIBUTED FEEDBACK LASER WITH Y-BRANCHING WAVEGUIDE AND A MONITORING PHOTODETECTOR GROWN BY METALORGANIC CHEMICAL VAPOR DEPOSITION'**
- **Br. Telecom. Technol. J. vol. 6 no.3. July 1988 pages 5-17**

## Beschreibung

Die Erfindung betrifft eine optoelektronische Anordnung gemäß dem Oberbegriff des Patentanspruchs 1.

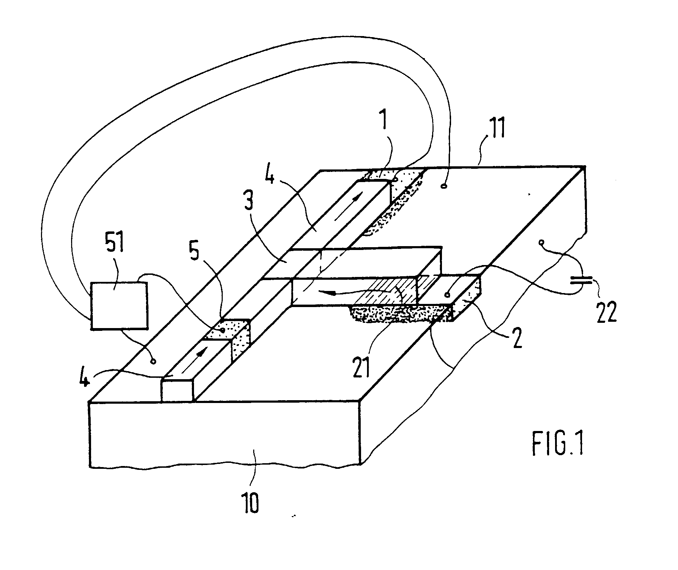

In der Druckschrift WO-A 85 04985 ist im Zusammenhang mit Fig. 1 und 2 eine derartige optoelektronische Anordnung beschrieben.

Optische Bauelemente, die als Polarisatoren, Modulatoren, optische Schalter eingesetzt werden, werden heute hybrid, z.B. seitlich des Halbleitersubstrats angeordnet, da Kristalle aus Lithiumniobat oder Kaliumtitanylphosphat, die sich für solche Bauelemente eignen, nicht monolithisch integrierbar sind und zudem viel Platz erfordern.

Aus Br. Telecom. Technol. J. 6 No 3 (1988), S. 5-17, sind polymere Kunststoffe bekannt, die nicht-lineare optische Eigenschaften haben und von denen man glaubt, daß sie an die Stelle der bekannten optischen Bauelemente treten können.

Optisch nichtlineare Kunststoffe sind entweder Abkömmlinge des bei normaler Umgebungstemperatur flüssigen Nitrobenzols oder stammen aus der Familie des Polydiacethylens. Entscheidend für das Zustandekommen dieser optischen Eingenschaften ist, daß Einfach- und Doppelbindungen zwischen den Kohlenstoffatomen abwechselnd auftreten.

Auf das elektrische Feld E elektromagnetischer Strahlung reagiert ein derartiger Kunststoff mit einer dielektrischen Polarisation P, die sich als Potenzreihe des elektrischen Feldes E ausdrücken läßt:

$$P = \varepsilon_0 \left( \chi^{(1)}E + \chi^{(2)}E^2 + \chi^{(3)}E^3 \dots \right)$$

Dabei bedeuten $\varepsilon_0$ die Dielektrizitätskonstante und $\chi^{(i)}$ die Suszeptibilität i-ter Ordnung. Die Suszeptibilität erster Ordnung, $\chi^{(1)}$, zeigt Effekte, die sich auch schon bei geringen Stärken des E-Feldes beobachten lassen. Sie ist die Ursache für den Brechungsindex und die Absorption des Materials.

Die nicht-linearen Eigenschaften resultieren jedoch aus den Suszeptibilitäten höherer Ordnung, $\chi^{(2)}, \chi^{(3)}, \dots$.

Aufgrund der Suszeptibilität $\chi^{(2)}$ zeigen die polymeren Kunststoffe einen vom Quadrat des elektrischen bzw. des magnetischen Feldes abhängigen Brechungsindex, den Pockels-Effekt bzw. den Faraday-Effekt.

Daraus resultieren die Erzeugung von Oberwellen der doppelten Frequenz, das Mischen von Frequenzen und die parametrische Verstärkung einer Frequenz auf Kosten einer anderen Frequenz.

Dem zuletzt genannten Artikel läßt sich jedoch nicht entnehmen, auf welche Weise sich polymere Kunststoffe für die optische Nachrichtenübertragung verwenden lassen.

Es ist Aufgabe der Erfindung, eine höher integrierbare optoelektronische Schaltungsanordnung einschließlich ihres Herstellungsverfahrens anzugeben, in der die Vorzüge eines optisch nicht-linearen polymeren Kunststoffes für die optische Nachrichtenübertragung genutzt werden können.

Diese Aufgabe wird durch die Merkmale des Anspruchs 1 gelöst.

Die Herstellung einer derartigen Schaltungsanordnung ist in Anspruch 4 angegeben.

Es sind zwar bereits integrierte Schaltungen mit optisch nicht-linearen Werkstoffen zur Umwandlung von elliptisch polarisierter optischer Strahlung in linear polarisierte optische Strahlung bekannt (s. z.B. A. Schlachetzki "Integrierte Optik mit Halbleitern" in Phys. Bl. 44 (1988) Nr. 4, Seiten 91 ff), diese Schaltungen verwenden jedoch ausschließlich Halbleiter, die den elektrooptischen Effekt zeigen, wie GaAs oder InP, oder das zum Aufbau integrierter Schaltungen ungeeignete Lithiumniobat (s. z.B. o.g. Aufsatz, Seite 93, mittlere und rechte Spalte).

Gegenüber Halbleitern haben optisch nichtlineare Polymere den Vorteil, daß sie einfacher und kostengünstiger auf ein Substrat aufgebracht werden können und daß ihre optisch nichtlinearen Eigenschaften ausgeprägter sind als bei anorganischen Kristallen und leicht mittels eines angelegten elektrischen Feldes verändert und so an den jeweiligen Einsatzfall angepaßt werden können.

Weiterbildungen der Erfindung ergeben sich aus den Unteransprüchen.

Ausführungsbeispiele der Erfindung werden im folgenden anhand der Zeichnung erläutert.

Fig. 1    zeigt eine optoelektronische Anordnung mit einem optischen Empfänger

Ein optischer Empfänger besteht aus einer Photodiode 1 zum Empfang von Lichtsignalen, einem Halbleiterlaser 2 als Lokal- oszillator, einem Wellenleiter 4, einem Polarisator 5 und einem Richtkoppler 3, die sämtlich auf einem Halbleitersubstrat 10 integriert sind.

Diese Anordnung wird als monolithisch angesehen, weil sie auf einem Halbleitersubstrat nur durch Verfahrensschritte wie Aufdampfen und Dotieren zustandegekommen ist, d.h. ohne Löten, Kleben, Pressen, etc.

Der Halbleiterlaser 2, der z.B. ein einmodiger DFB-(distributed feedback)-Laser sein kann, weist einen Bragg-Reflektor 21 auf und wird über eine Stromquelle 22 gesteuert.

Er dient als Lokaloszillator und sendet Licht einer festen Frequenz aus, das in dem Richtkoppler 3 dem über den Wellenleiter 4 empfangenen Licht überlagert wird. Da der hier dargestellte Wellenleiter 4 nur das Endstück einer viele Kilometer langen Übertragungstrecke darstellt, ist der Polarisationszustand der optischen Strahlung beliebig; daher wird der Polarisationszustand über den Polarisator 5 nachgeführt, um die richtige Polarisationslage für den Lokaloszillator zu erhalten. Er wandelt das im allgemeinen Fall elliptisch polarisierte Licht in linear polarisiertes um, damit der nachfolgende Richtkoppler 3 eine einwandfreie Überlagerung mit dem linear polarisierten Licht des Halbleiterlasers 2 gestattet.

Der Polarisator 5 besteht aus einem polymeren Kunststoff und hat eine Dicke

$$d = \frac{\lambda}{4\,(n_{ao} - n_o)}$$

Der Polarisator 5 ist ein $\lambda/4$-Plättchen mit einem ordentlichen Brechungsindex $n_o$ und einem außerordentlichen Brechungsindex

$n_{ao}$. Dabei bedeutet
$\lambda$ die Lichtwellenlänge im Vakuum.

An den Polarisator 5 wird mit einer Steuereinheit 51 ein elektrisches Feld angelegt, durch das sich aufgrund des Pockels-Effekts oder des Kerr-Effekts die Polarisationsrichtung des Lichtes nachstellen läßt. Der Strom, den die Steuereinheit 51 liefert, läßt sich in Abhängigkeit des Stromes regeln, der in der Photodiode fließt.

Diese hat elektrische Anschlüsse 11, über die der Steuereinheit 51 ein Regelstrom zugeführt wird.

Die Herstellung einer derartigen Schaltungsanordnung entspricht in allem dem bekannten Herstellungsprozeß. Nacheinander werden auf dem Halbleitersubstrat 10 weitere Halbleiterschichten unterschiedlicher Zusammensetzung epitaktisch abgeschieden und nach Erfordernis zur Änderung der elektrischen Leitfähigkeit oder des Brechungsindex auch dotiert.

Der Lichtwellenleiter 4 wird ebenfalls epitaktisch hergestellt. Er besteht aus Halbleiterschichten oder Siliziumverbindungen (z.B. Siliziumdioxid, Siliziumnitrid). Er erhält im Lithographieschritt eine Ausnehmung, in die nach Abdeckung der übrigen Bauelemente der polymere Kunststoff eingebracht wird, der den Polarisator 5 bildet. Danach werden durch eine Kontaktmaske die elektrischen Kontakte für die Photodiode 1, den Halbleiterlaser 2 und den Polarisator 5 aufgedampft.

## Patentansprüche

1. Optoelektronische Anordnung, die auf einem Halbleitersubstrat (10) integrierte Bestandteile enthält, von denen mindestens eines aus einem polymeren Kunststoff besteht,
**dadurch gekennzeichnet,**
daß das aus polymerem Kunststoff bestehende optische Bauelement ein als $\lambda/4$-Plättchen ausgebildeter, in einer Ausnehmung eines Lichtwellenleiters (4) angeordneter Polarisator (5) ist, dessen optische Länge durch ein elektrisches Feld steuerbar ist, das über einen auf dem Polarisator angebrachten elektrischen Kontakt auf das Polarisatormaterial einwirkt.

2. Optoelektronische Anordnung nach Anspruch 1, dadurch gekennzeichnet,

   - daß sich auf dem Halbleitersubstrat (10) eine optische Empfangseinrichtung mit einer Photodiode (1), einem einen Lokaloszillator bildenden einmodigen Halbleiterlaser (2), einem Lichtwellenleiter (4), einem Richtkoppler (3) und dem Polarisator (5) befinden, durch den aus dem Lichtwellenleiter kommendes, elliptisch polarisiertes Licht linear polarisiert wird.

3. Optoelektronische Anordnung nach Anspruch 2, dadurch gekennzeichnet,

   - daß der Polarisator (5) bei einer Änderung der Intensität des Lichts über eine von der Photodiode (1) erzeugte Regelgröße durch das elektrische Feld so nachgeregelt wird, daß das in die Photodiode (1) eingespeiste Licht die maximale Intensität hat.

4. Verfahren zur Herstellung einer optoelektronischen Anordnung nach Anspruch 2, dadurch gekennzeichnet,

   - daß nacheinander Halbleiterschichten epitaktisch auf dem Halbleitersubstrat (10) abgeschieden und teilweise zur Änderung ihrer elektrischen Leitfähigkeit oder des Brechungsindex durch Diffusion dotiert werden,
   - daß der Lichtwellenleiter (4) ebenfalls epitaktisch hergestellt wird und aus Halbleiterschichten oder aus Siliziumverbindungen besteht und lithographisch eine Ausnehmung erhält,
   - daß in die Ausnehmung der polymere Kunststoff abgeschieden wird, der den Polarisator (5) bildet, und
   - daß anschließend elektrische Kontakte für die Photodiode (1), den Halbleiterlaser (2) und den Polarisator (5) durch eine Kontaktmaske aufgedampft werden.

## Claims

1. Optoelectronic device which comprises components integrated on a semiconductor substrate (10), at least one of which is composed of a polymeric plastics material,
characterized
in that the optical component composed of polymeric plastics material is a polarizer (5) which is designed as a $\lambda/4$ plate and is disposed in a recess in an optical waveguide (4) and whose optical length is controllable by an electrical field which acts via an electrical contact on the polarizer material, which contact is mounted on the polarizer.

2. Optoelectronic device according to Claim 1, characterized

- in that there are situated on the semiconductor substrate (10) an optical receiving device comprising a photodiode (1), a monomode semiconductor laser (2) which forms a local oscillator, an optical waveguide (4), a directional coupler (3) and the polarizer (5), which linearly polarizes the elliptically polarized light coming from the optical waveguide.

3. Optoelectronic device according to Claim 2, characterized

- in that, in the event of a change in the intensity of the light, the polarizer (5) is adjusted by the electric field via a controlled variable generated by the photodiode (1) so that the light injected into the photodiode (1) has the maximum intensity.

4. Method of producing an optoelectronic device according to Claim 2, characterized

- in that semiconductor layers are consecutively deposited epitaxially on the semiconductor substrate (10) and doped by diffusion so as partially to change their electrical conductivity or the refractive index,
- in that the optical waveguide (4) is likewise produced epitaxially and is composed of semiconductor layers or of silicon compounds and is photolithographically provided with a recess,
- in that the polymeric plastics material which forms the polarizer (5) is deposited in the recess, and
- in that electrical contacts for the photodiode (1), the semiconductor laser (2) and the polarizer (5) are then vapour-deposited through a contact mask.

**Revendications**

1. Dispositif optoélectronique, qui contient des composants intégrés sur un substrat semi-conducteur (10), dont au moins un est à base d'un plastique polymère, caractérisé en ce que le composant optique à base de plastique polymère est un polarisateur (5) conçu comme une plaquette de lonaueur d'onde λ/4 et disposé dans une cavité d'un guide d'onde de lumière (4), dont la longueur optique peut être contrôlée par un champ électrique, qui agit sur le matériau du polarisateur par l'intermédiaire d'un ccntact électrique appliqué sur le polarisateur.

2. Dispositif optoélectronique selon la revendication 1, caractérisé en ce qu'il se trouve sur le substrat à semi-conducteur (10) un dispositif de réception optique avec une photodiode (1), un laser à semi-conducteur (2) monomode formant un oscillateur local, un guide d'onde de lumière (4), un coupleur directif (3) et le polarisateur (5), par lequel de la lumière arrivant du guide d'onde de lumière et polarisée au plan elliptique est polarisée au plan linéaire.

3. Dispositif optoélectronique selon la revendication 2, caractérisé en ce que le polarisateur (5) est rajusté par le champ électrique dans le cas d'une variation de l'intensité de la lumière par une grandeur de réglage générée par la photodiode (1), de sorte que la lumière injectée dans la photodiode (1) a l'intensité maximale.

4. Procédé pour la fabrication d'un dispositif optoélectronique selon la revendication 2, caractérisé en ce que les couches semi-conductrices sont déposées de façon successive et épitaxiale sur le substrat semi-conducteur (10) et sont dopées par diffusion en partie pour faire varier leur conductivité électrique ou l'indice de réfraction, en ce que le guide d'onde de lumière (4) est également fabriqué de façon épitaxiale et comprend des couches semi-conductrices ou des composés de silicium et reçoit une cavité par lithographie, en ce que le plastique polymère formant le polarisateur (5) est déposé dans la cavité et en ce qu'ensuite les contacts électriques sont métallisés sous vide par un masque de contact pour la photodiode (1), le laser à semi-conducteur (2) et le polarisateur (5).

FIG.1